# EUROPEAN PATENT SPECIFICATION

(11) **EP 1 356 496 B1**
(45) Date of publication and mention of the grant of the patent: **17.09.2008**
(21) Application number: 01271645.2
(22) Date of filing: 14.12.2001
(51) Int. Cl.: H01J 37/32

(54) **Apparatus for evaporation of materials for coating objects**
Gerät zur Verdampfung von Werkstoffen zur Beschichtung von Gegenständen
Appareil pour l'evaporation de matériaux pour le revètement d'objets

(30) Priority: 18.12.2000 CZ 20004747
(43) Date of publication of application: 29.10.2003
(73) Proprietor: SHM, s.r.o., 787 01 Sumperk (CZ)
(72) Inventor: HOLUBAR, Pavel, 787 01 Sumperk (CZ); JILEK, Mojmir, 787 01 Sumperk (CZ)
(74) Representative: Smola, Josef
(86) International application number: PCT/CZ2001/000075
(87) International publication number: WO 2002/050864

(56) References cited:
- EP-A- 0 899 773
- WO-A-85/03954
- WO-A-99/27758
- DD-A- 123 952
- US-A- 5 814 195

## Description

### Field of invention

The invention relates to an apparatus for evaporation of materials for coating of objects by a physical method using low voltage electric arc, such apparatus being equipped with a source of magnetic field and with an anode and a cathode of electric arc.

### Background of invention

Various devices for the deposition of hard coatings using a physical method, i.e. Physical Vapour Deposition (PVD), are known.

Technologies are known using low voltage arc for evaporation of particles that create a coating on a substrate/object to be coated under gaseous atmosphere. The produced coating can be of the TiN type. In such case the mass of the coating is removed from the surface of a metallic target, e.g. made of titanium, by evaporation using a low voltage electric arc.

In case dc low voltage electric arc is employed as a source for evaporation of material, the burning of the arc may be uncontrolled, or it can be controlled by a magnetic field. In both cases the evaporation of material occurs in the place of the cathode spot moving over the cathode surface of the low voltage arc. In the area of the cathode spot a microbath is created achieving temperatures of the order of 10 000 °C. In the area of the microbath an intense evaporation and spluttering of the cathode material is seen. The evaporated material settles on the surface of objects to be coated in atomary or molecular form, while the spluttered part of material settles in form of macroparticles. The largest amount of macroparticles originates in case of applying non-controlled low voltage arc. Such solution is described, e.g., in the article Pokrytia polucennye kondenzaciei plazmennykh potokov v vakuume, Ukrainskii fiziceskii zumal, Tom 24, No 4, Otdelnyj ottisk, Kiev - 1070.

The drawback of such solution consists in particular in that the macroparticles impair the physical and chemical properties of the coating.

In the case of an arc controlled by magnetic field the motion of the cathode spot can be substantially accelerated, see e.g. WO 85/03954 and US 4,637,477 where the cathode is planar. This results in reduced diameter of the microbath in the area of the cathode spot and in reduced numbers of originating macroparticles. The arc moves in particular in the region of high magnetic field intensity, and namely in perpendicular direction to the magnetic field lines of force. Due to that a region with more pronounced erosion develops on the electrode surface. In the course of decreasing thickness of the electrode, i.e. cathode, in the region of its erosion, the area of the arc motion approaches the source of magnetic field, which leads to growing intensity of magnetic field in the given place. Accordingly, the motion of the cathode spot gets more and more focussed in a restricted area, until the arc will cut into one single track. This will considerably reduce the life of the cathode.

The problem of cutting the path of the arc is partially solved by a technology using a plurality of magnetic field sources for the control of the arc motion, such as electromagnetic coils, see the example of the disclosed international application WO 95/06954. Shifting the region of magnetic field of the highest intensity can result in more uniform erosion of the cathode surface.

This purpose can be served, e.g., by two electromagnetic coils in different locations. By changing the intensity of current applied to single coils the position of maximum magnetic field intensity upon the electrode surface can be varied. It is a disadvantage of such technology that the magnetic field motion cannot be controlled uniformly enough upon the whole cathode surface, thus only delaying the moment of irregular wear of the electrode. Accordingly, only a limited part of the electrode material can be utilised for depositing the coating.

Another known technology consists in the mechanical motion of a relatively small permanent magnet or electromagnet behind the electrode, i.e. the cathode of low voltage arc, such as the disclosed international application WO 85/03954. The drawback of this technology is the fact that only a small part of the electrode surface is covered by magnetic field. Under higher currents in the low voltage arc the arc can penetrate down to the area with low magnetic field intensity, which again results in growing numbers of macroparticles.

EP-A-0 899 773 discloses a compact cylindrical cathode. Nearby the cathode a plurality of side magnets are placed. It is inconvenient that the cathode is rather small and has to be often exchanged. Besides it is not suitable for long tool coating. WO 99/27758 A discloses a plasma processing apparatus with an adjustable time variable magnetic field using a pair of rotary permanent magnet system. In practice it is not suitable to use for PVD arc technology.

Another known technology is ion induced sputtering, described for example in US 5,814,195 and DD123952. This technology uses a glow discharge, which operates at a high voltage in order to accelerate ions to high energies of several 100 eV and relatively low density of the ion current of several mA/cm². Devices working with this technology operate in the magnetron mode. One of drawbacks of the technology of ion induced sputtering is demand of much energy. Besides, using this technology a closed magnetic field cannot be created and so the movement of charged particles on a closed trajectory above the surface of the cathode cannot be established. This facts limit the possibility to achieve a good utilisation of material of evaporating electrodes.

It is the aim of the present invention to create a solution allowing substantially better utilisation of material of the evaporation electrode, while maintaining the coating quality on the substrate, in particular by achieving very low quantities of originating macroparticles.

### Summary of the invention

The disadvantages of the known solutions are substantially removed by the solution according to the invention, the essence of which consists in that at least two cathodes are arranged symmetrically with respect to an anode and sources of magnetic field are accommodated inside the cathodes and the cathodes and the sources are arranged to pivot with respect to one another in a coating chamber, the cathodes being cylindrical.

It is also substantial that the sources of magnetic field consist of at least one magnetic coil or at least one permanent magnet.

It is advantageous that the sources of magnetic field consist of a combination of at least one permanent magnet and at least one magnetic coil.

The cathodes can be arranged so as to pivot or immovable. The sources of magnetic field can be arranged so as to pivot or immovable. In any case the cathodes and the sources are arranged to pivot with respect to one another.

It is advantageous that the cathodes can be arranged in the central region of the coating chamber or between the wall of coating chamber and the objects to be coated.

If the evaporating apparatus has been eccentrically arranged at the wall of the coating chamber, it is preferable to divide the anode at least in two sections arranged at the sides of the cathode. This allows at least two cathodes to be accommodated between single sections of the anode.

The advantage of the solution according to the present invention consists in that the uniform mechanical motion of the magnetic field with respect to the surface of the cathode being evaporated considerably extends the life of the cathode.

Another advantage consists in that a hollow cathode of cylindrical form has a considerably larger surface than a planar electrode occupying the same space within a coating chamber. This is beneficial particularly in cases requiring to evaporate two materials at a time and requiring the growing layer to have very regular composition in various places of the layer being deposited. This requires the diameter of the cathodes to be as small as possible.

Another advantage consists in that the length of the source of the magnetic field approximately equals the length of the hollow cathode. The circumstance that the magnetic field is considerably vast can prevent the extension of the arc into places with low magnetic field intensity, although the low voltage current may achieve high values. This results in acceptably small quantities of macroparticles even under high velocities of coating growth.

Yet another advantage consists in that a simple replacement of a source of magnetic field by a more powerful source and a replacement of the source of low voltage arc by a source for magnetron pulverisation enable the apparatus to operate also in the mode of magnetron powder coating.

### Brief description of the drawings

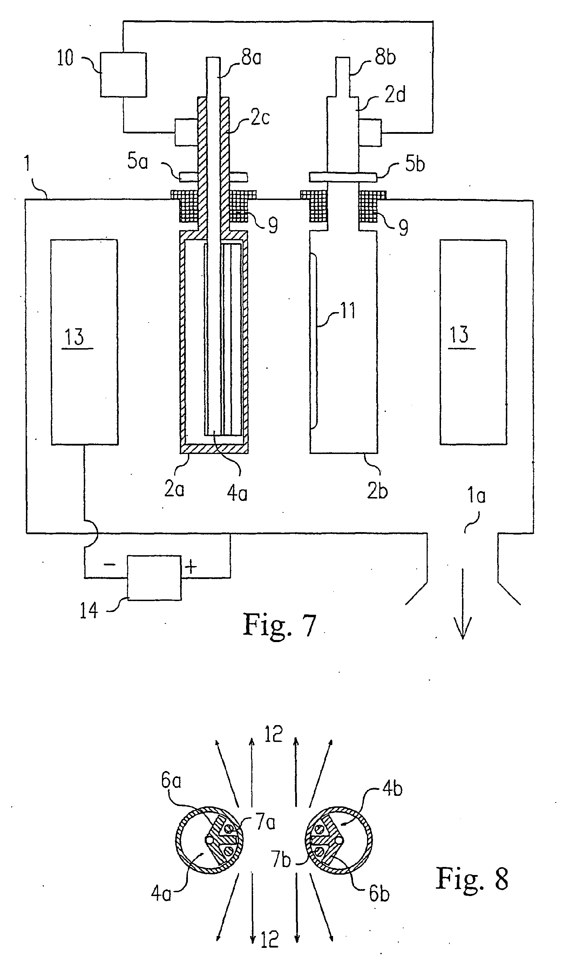

Further advantages and features of the invention ensue from the following description based upon drawings where Fig. 1 slows a diagrammatical front elevation of the first embodiment of the invention, Fig. 2 a diagrammatical layout of the first embodiment in partial section, Fig. 3 a diagrammatical front elevation of the second embodiment, Fig. 4 a schematic layout of the second of embodiment in partial section, Fig. 5 a diagramatical front elevation of a first example, Fig. 6 a diagrammatical layout of the first example in partial section, Fig. 7 a diagramatical front elevation of a second example, and Fig. 8 a diagramatical layout of the second example in partial section.

### Samples of embodiment of the invention

The descriptions of various examples and embodiments are provided with the same reference numbers for the same parts, or possibly for the parts executed in the same way. In some cases the identical parts used repeatedly bear the same reference numbers differentiated with added letters.

### Embodiment 1

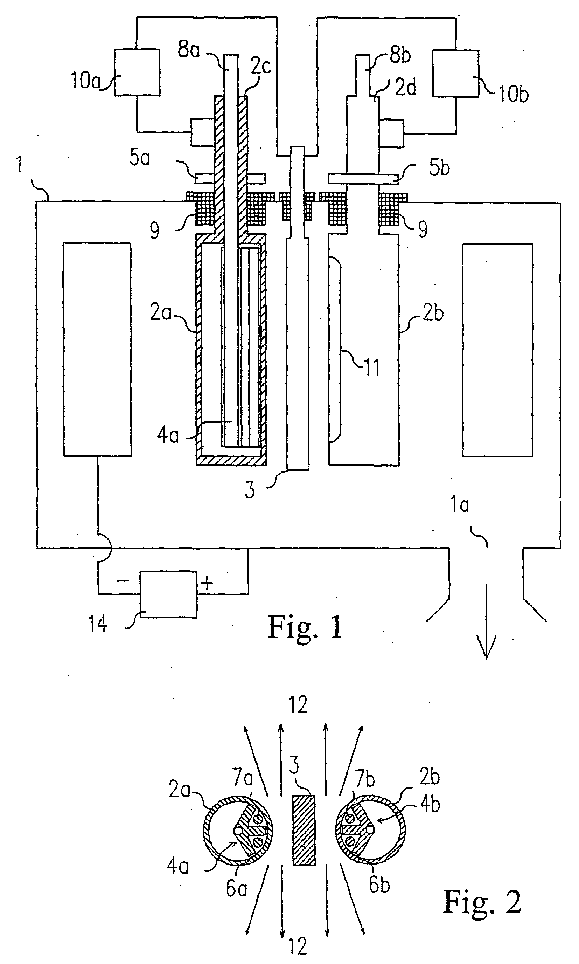

The centre of the coating chamber 1 (Fig. 1) accommodates an apparatus for evaporation of materials according to the invention that is referred to as evaporating device in the further description. The coating chamber 1 is provided by outlet 1 a for gas evacuation. The basic parts of the evaporating device are cathodes 2a and 2b of the low voltage arc, anode 3 of the low voltage arc and source 4a and 4b of magnetic field (Figs 1 and 2). Cathodes 2a and 2b are cylindrical, i.e. they have cylindrical form, they are hollow and at least their outer surface is made of material suitable for evaporation by the method of low voltage arc for coating by physical vapour deposition method, such as titanium or aluminium. Cathodes 2a and 2b pivot on their bearing parts 2c and 2d using not illustrated bearings. The bearing parts 2c and 2d of cathodes 2a and 2b are provided with pulleys 5a and 5b that are linked with a not illustrated driving mechanism. Cathodes 2a and 2b accommodate, in their inside, the sources 4a and 4b of magnetic field that are created by pole shoes 6a and 6b and electromagnetic coils 7a and 7b composing together an electromagnet. The pole shoes 6a and 6b are made of magnetically soft material, they are connected by electromagnetic coils 7a and 7b and rigidly held in a not illustrated frame by carriers 8a and 8b, so as to allow the pole shoes 6a and 6b to be directed to the centre of coating chamber 1. Approximately in the centre of coating chamber 1, between first cathode 2a and second cathode 2b, the anode 3 of the low voltage arc is immovably located.

The not illustrated current connections for electromagnetic coils 7a and 7b pass through the carriers 8a and 8b. Cathodes 2a and 2b are electrically separated by insulation 9 from the coating chamber 1. Sources 10a and 10b of low voltage arc are inserted between anode 3 and cathodes 2a 2b. Current is brought to cathodes 2a and 2b by not illustrated current busses. Both cathodes 2a and 2b are water-cooled by means of a not illustrated known cooling system.

According to the embodiment the basic dimensions of the parts of the evaporating device are as follows: the outer diameter of cathodes 2a, 2b is 80 mm, the internal diameter of cathodes is 60 mm, the height of cathodes 2a and 2b is 300 mm, the distance between cathodes 2a, 2b is 50 mm, the water cooled electromagnetic coils 7a and 7b are characterised by 100 threads and maximum current 20 A, the total height of electromagnetic coils 7a and 7b is 250 mm and the distance of cathodes 2a and 2b from the substrate is 150 mm.

After the ignition of the electric arc by a not illustrated ignitor, attached, e.g., at the bottom or at the wall of coating chamber 1, the arc moves in the region of the strongest magnetic field perpendicularly to the lines of force of the magnetic field along an elongated trajectory 11 between both poles of the electromagnet, the trajectory 11 being directed towards the centre of coating chamber 1. This accounts for the gradual change of the area on both cathodes 2a and 2b from which the material is being evaporated, during the regular rotation of cathodes 2a and 2b. Thanks to the regular mechanical motion of cathodes 2a and 2b the cathode spot can regularly travel and the removal of material from cathodes 2a and 2b is uniform almost over their complete surface. The evaporated particles move in direction 12 (Fig. 2) to the not illustrated substrate/object to be coated that is located in region 13. As shown in Fig. 1, negative voltage from a dc source 14 is applied to the objects to be coated, the positive pole being connected with coating chamber 1.

### Embodiment 2

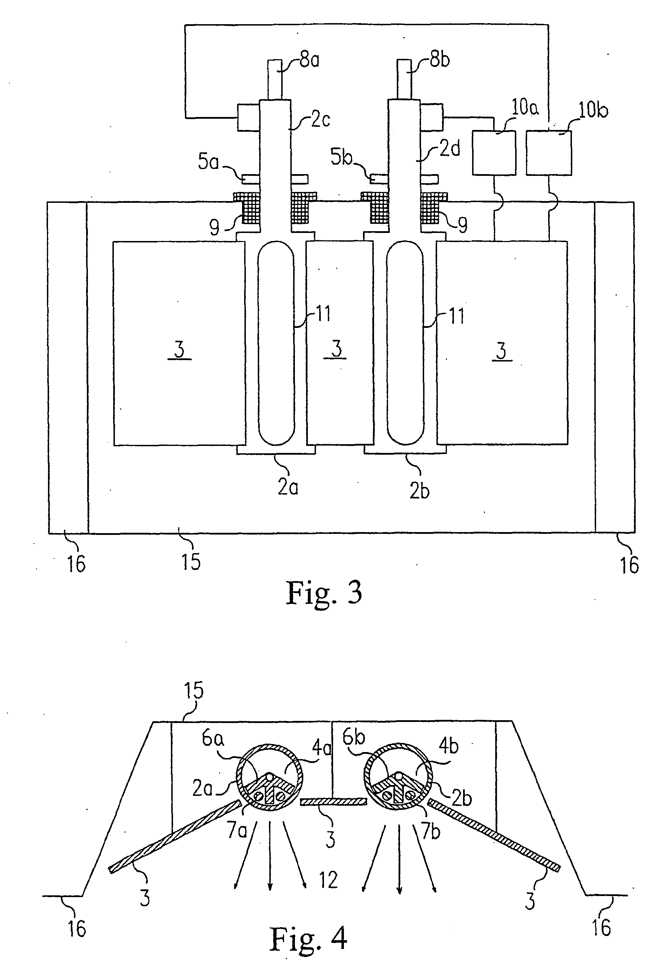

The not illustrated coating chamber is provided with door 15 attached to it over flange 16 (Figs. 3 and 4). Door 15 is placed in the wall of a not illustrated coating chamber, being conductively connected with the latter and creating a closed space with it. The door 15 accommodates the evaporating device. The basic parts of the evaporating device are cathodes 2a and 2b of the low voltage arc, anode 3 of the low voltage arc and source 4a and 4b of magnetic field. Cathodes 2a and 2b pivot similarly as in example 1, their rotary motion being derived from pulleys 5a and 5b. Cathodes 2a and 2b accommodate, in their inside, the sources 4a and 4b of magnetic field that are created by pole shoes 6a and 6b and electromagnetic coils 7a and 7b. The pole shoes 6a and 6b are made of magnetically soft material, they are fixed by electromagnetic coils 7a and 7b and rigidly held by carriers 8a and 8b similarly as in embodiment 1, so as to allow the pole shoes 6a and 6b to be directed to the centre of coating chamber 1. The not illustrated current connections for electromagnetic coils pass through the carriers 8a and 8b. Cathodes 2a and 2b are electrically separated by insulation 9 from the coating chamber. Sources 10a and 10b of low voltage arc are inserted between the anode 3 that is conductively connected with door 15 and cathodes 2a, 2b. Anode 3 is multiple, in this example consisting of three parts. Current is brought to cathodes 2a and 2b by not illustrated current busses. Both cathodes 2a and 2b are water-cooled by means of a not illustrated known cooling system.

According to embodiment 2 the basic dimensions of the parts of the evaporating device are as follows: the outer diameter of cathodes 2a, 2b is 80 mm, the internal diameter of cathodes is 60 mm, the height of cathodes 2a and 2b is 300 mm, the distance between cathodes 2a, 2b is 50 mm, the water cooled electromagnetic coils 7a and 7b are characterised by 100 threads and maximum current 20 A, the total height of electromagnetic coils 7a and 7b is 250 mm and the distance of cathodes 2a and 2b from the substrate is 150 mm. Accordingly, they are identical as in example 1.

After the ignition of the electric arc by a not illustrated ignitor, attached, e.g., at the bottom part of door 15, the arc moves in the region of the strongest magnetic field perpendicularly to the lines of force of the magnetic field along trajectory 11. Thus the areas on cathodes 2a and 2b, from which their material evaporate, gradually change during the rotation of cathodes 2a and 2b. Thanks to the regular mechanical motion of cathodes 2a and 2b the cathode spot can regularly travel and the removal of material from cathodes 2a and 2b is uniform almost over their complete surface. The evaporated particles move in direction 12 to the not illustrated substrate.

### Example 1

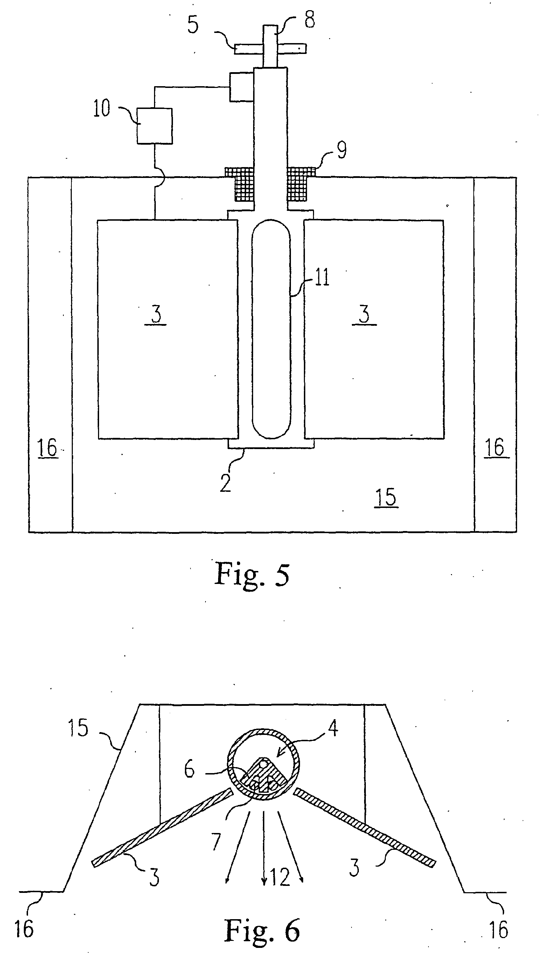

Door 15 (Figs. 5 and 6), which is placed similarly as in embodiment 2 in the wall of a not illustrated coating chamber, with which it is conductively connected, accommodates an evaporating device. The basic parts of the evaporating device are cathode 2 of the low voltage arc, anode 3 of the low voltage arc and source 4 of magnetic field. Cathode 2 is cylindrical and immovable, however, it is arranged adjustably or shiftably in order to be either only turnable or turned and adjusted, e.g., by manual setting. The arrangement allows adjusting to three positions by 120° increments. Anode 3 is immovable.

Cathode 2 accommodates in its inside the source 4 of magnetic field created by pole shoe 6 made of magnetically soft material and an electromagnetic coil 7 firmly connected with it. This system, i.e. the whole source 4 of magnetic field, pivots inside cathode 2 or has the possibility to turn around the axis of cathode 2 by pulley 5 accommodated on carrier 8 that is turnably supported in a not illustrated frame. The degree of turning must allow at least 30° to both sides from the central position. Generally the source 4 of magnetic field is directed towards the centre of the coating chamber. The not illustrated current supply wires for the electromagnetic coil 7 pass through carrier 8. Cathode 2 is electrically separated from door 15 of coating chamber by insulation 9. Source 10 of low voltage is inserted between anode 3 being electrically conductively connected with door 15 and cathode 2. Cathode 2 is water cooled in analogy with the previous examples. The relative arrangement of cathode and anode allows anode 3 to be divided in two sections, cathodes 2 being accommodated between them. A plurality of cathode 2 can be arranged between the sections of anode 3 or, more generally, at least two cathodes 2 can be arranged adjacent to each other.

The basic dimensions of the parts of the evaporating device are the same as in embodiments 1 and 2.

After the ignition of the electric arc by a not illustrated ignitor, attached, e.g., at the bottom part of the door, the arc moves in the region of the strongest magnetic field perpendicularly to the lines of force of the magnetic field along trajectory 11. By turning the source 4 of magnetic field by 30° to both sides from the central position, accordingly, the area on the surface of cathode 2 from which the material of cathode 2 is evaporated, gradually changes. After the cathode has become worn in the given position, such as after 30 processes, it can be re-adjusted or manually set to the next position. It is preferable to reset it gradually it into three positions by steps of 120°. One process is understood to be the operation of depositing a full coating on one batch of objects to be coated. It is obvious, according to the operation conditions, that cathode 2 can be re-adjusted between the processes only.

Due to the regular motion of the magnetic field, caused by regular incremental turning of source 4 of magnetic field, the cathode spot can travel uniformly and the removal of material from cathode 2 is almost uniform in the given position of cathode. The evaporated particles move in direction 12 towards the not illustrated substrate.

### Example 2

The centre of the coating chamber 1 accommodates an evaporating device with many parts arranged in analogy with embodiment 1. The basic parts of the evaporating device are electrodes 2a and 2b of the low voltage arc and source 4a and 4b of magnetic field. Electrodes 2a and 2b are cylindrical, i.e. they have cylindrical or similar form, they are hollow and at least their outer surface is made of material suitable for evaporation by the method of low voltage arc for coating by physical vapour deposition method (PVD), such as titanium or aluminium. Electrodes 2a and 2b pivot on their bearing parts 2c and 2d using not illustrated bearings. The bearing parts 2c and 2d of electrodes 2a and 2b are provided with pulleys 5a and 5b that are linked with a not illustrated driving mechanism. Cathodes 2a and 2b accommodate, in their inside, the sources 4a and 4b of magnetic field that are created by pole shoes 6a and 6b and electromagnetic coils 7a and 7b. The pole shoes 6a and 6b are made of magnetically soft material, they are firmly connected with electromagnetic coils 7a and 7b and rigidly held in a not illustrated frame by carriers 8a and 8b, so as to allow the pole shoes 6a and 6b to be directed to the centre of coating chamber 1. Not illustrated power supply wires for electromagnetic coils 7a and 7b pass through carriers 8a and 8b. Electrodes 2a and 2b are electrically separated from the coating chamber 1 by insulation 9. Alternating power source 10 of low voltage arc is inserted between the electrodes 2a and 2b.

Electrodes 2a and 2b get power supply from not illustrated current busses. Both electrodes 2a and 2b are water-cooled by means of a not illustrated known cooling system.

According to the example the basic dimensions of the parts of the evaporating device are as follows: the outer diameter of electrodes 2a, 2b is 80 mm, the internal diameter of electrodes is 60 mm, the height of electrodes 2a and 2b is 300 mm, the distance between electrodes 2a, 2b is 50 mm, the water cooled electromagnetic coils 7a and 7b are characterised by 100 threads and maximum current 20 A, the total height of electromagnetic coils 7a and 7b is 250 mm and the distance of electrodes 2a and 2b from the substrate is 150 mm.

The source 10 of electric low voltage arc is alternating, i.e. the electrodes 2a and 2b are under alternating electric tension, for instance with pulse period of 2 seconds. The pulse form of the low voltage arc is approximately rectangular. During the first part T1 of each pulse period the first electrode 2a operates as cathode of the low voltage arc and the second electrode 2b as its anode. During the second part T2 of the pulse period the second electrode 2b is the cathode of the low voltage arc and first electrode 2a its anode. The ratio T1/T2 can be used for changing the stoichiometry of the layer.

The description of the examples and the embodiments help to better understanding of the following facts: At least one cathode 2a, 2b, 2 and at least one source 4a, 4b, 4 of the magnetic field are arranged in coating chamber 1 so as to pivot against each other. Further cathodes and sources of magnetic field that have the same arrangement, i.e. can pivot with respect to one another, can be accommodated in the coating chamber.

The cathode 2a, 2b, 2 of evaporated material is a hollow electrode of approximately cylindrical shape. It is usually arranged vertically and its length considerably exceeds its diameter. This electrode can rotate around its axis, the source 4a, 4b, 4 of the magnetic field being immovable or, possibly, source 4a, 4b, 4 of the magnetic field accommodated inside cathode 2a, 2b, 2 can turn or incrementally turn around the axis of immovable hollow cathode 2a, 2b, 2. The length of source 4a, 4b, 4 of magnetic field equals approximately the length of cathode 2a, 2b, 2,

The evaporating device consisting of cathode 2a, 2b, 2 and anode 3 and source 4a, 4b, 4 of magnetic field can be accommodated in the centre of coating chamber 1 or close to the wall of coating chamber 1, i.e. between the wall of coating chamber 1 and the object to be coated.

If the evaporating device is located in the centre of the coating chamber 1, in the simplest case it can consist of one cathode and one anode and one source of magnetic field. The anode 3 is arranged approximately opposite source 4a, 4b of magnetic field. The cathode can be pivoted and during the operation of the apparatus it rotates; in such case the source of magnetic field is immovable and is permanently directed to the anode. If cathode 2 is immovable during the process, it is indispensable to have a movable source 4a, 4b of magnetic field. One preferable solution consists in reciprocating turning movement around the axis, e.g. within the range of 30° from the central position to both sides. In such case the central position of the source of magnetic field is directed to the anode. Since the electric arc burns only at a part of the electrode, in case of cathode 2 that is immovable during the process such cathode 2 can be turned between the processes. It is preferable to turn it by a certain increment at the moment a certain wear of cathode 2 can be established in the given position. It is preferable to arrange the evaporating device so as to allow the fixing of cathode 2 at least in two different positions; it is preferable to ensure the possibility of adjustment in three positions with steps of 120° each. The arrangement in a plurality of positions is possible. If the evaporating device is located in the centre of the coating chamber, such source can comprise also a plurality of cathodes. The optimum are two cathodes, 2b - in such case it is preferable to accommodate them symmetrically with respect to anode 3. The location of sources 4a, 4b of the magnetic field and the possible rotation of the electrode or of sources 4a, 4b of magnetic field are equal as in the case of one cathode. Substrates/objects to be coated are located around the evaporating device.

In all the examples and the embodiments of the invention the electromagnetic coils can be replaced by known permanent magnets having the same orientation of magnetic field as the described pole shoes of electromagnetic coils. It is also possible to combine electromagnetic coils and permanent magnets.

If the evaporating device is located in the vicinity of a wall of the coating chamber or, possibly, in the door of the coating chamber, in the simplest case it can consist of one anode 3 and one cathode 2 and of a source of magnetic field. In such case the anode consists of two parts symmetrically attached at the sides of cathode 2 so as to leave free space between cathode 2 and the objects to be coated that are located between the centre of the coating chamber and cathode 2. The magnetic field is directed to the centre of the chamber. Cathode 2 can pivot, i.e. during the operation of the apparatus it performs rotary motion - in such case source 4 of magnetic field is fixed. In case both the anode and the cathode are immovable during the process, source 4 of magnetic field must necessarily move. The optimum motion is reciprocating turnable motion around the axis, such as within the range of 30° from the central position to both sides. Since the electric arc bums on a part of the electrode only, it is possible to turn cathode 2, that is immovable during the process, between the processes. It is favourable to turn cathode 2 by increments, if it is worn in an existing position. It is suitable to arrange the evaporating device so as to allow the fixation of cathode 2 in three positions by steps of 120°. If the evaporating device is accommodated at the wall of the coating chamber, a plurality of cathodes can be located adjacent to one another. The anode can be accommodated between these cathodes, but it is not indispensable. The anode or the anodes of the low voltage arc can be in principle electrically connected with the coating chamber, but it is not mandatory.

The evaporating devices described in single examples or embodiments can represent one evaporating device unit, however, a plurality of such devices can be arranged in the coating chamber or, possibly, around the circumference of the coating chamber.

Another solution is possible allowing two electrodes positioned opposite each other or, possibly, adjacent to one another, said electrodes alternating as cathode and anode in case of applying an alternating source of low voltage arc.

### Industrial applicability

The apparatus according to the invention is intended for evaporation of materials from metallic targets by way of low voltage arc and is part of a unit intended for coating metallic and non metallic objects by physical vapour deposition method PVD. The invention will be particularly useful for providing machining tools with hard and very hard coatings.

Replacing the source of magnetic field by a stronger one and replacing the source of low voltage arc by a source for magnetron pulverisation enables the apparatus to operate also in the mode of magnetron powder coating of objects to be coated.

### List of parts

- 1: coating chamber
- 1a: outlet (for evacuation)
- 2: cathode
- 2a: cathode, electrode
- 2b: cathode, electrode
- 2c: bearing parts
- 2d: bearing parts
- 3: anode
- 4: source (of magnetic field)
- 4a: source (of magnetic field)
- 4b: source (of magnetic field)
- 5: pulley
- 5a: pulley
- 5b: pulley
- 6: pole shoes
- 6a: pole shoe
- 6b: pole shoe
- 7: electromagnetic coil
- 7a: electromagnetic coil
- 7b: electromagnetic coil
- 8: carrier
- 8a: carrier
- 8b: carrier
- 9: insulation
- 10: source (of arc)
- 10a: source (of arc)
- 10b: source (of arc)
- 11: trajectory
- 12: direction
- 13: region
- 14: dc source
- 15: door
- 16: flange (of door)

## Claims

1. Apparatus for evaporation of materials for coating objects by a physical method using a low voltage electric arc, such apparatus being equipped with a coating chamber (1), with an electric arc ignitor, with a source of magnetic field and with an anode (3) and a cylindrical cathode (2a) of electric arc, **characterized in that** it further comprises at least a second cylindrical cathode (2b) such that said at least two cathodes (2a, 2b) are arranged symmetrically with respect to said anode (3) and a source (4a, 4b) of magnetic field is accommodated inside each cathode (2a, 2b) such that each cathode (2a, 2b) and the source (4a, 4b) accommodated inside of it are arranged to pivot with respect to one another in said coating chamber (1).

2. Apparatus according to claim 1, **characterized in that** the sources (4a, 4b) of magnetic field consist of at least one magnetic coil (7a, 7b).

3. Apparatus according to claim 1, **characterized in that** the sources (4a, 4b) of magnetic field consist of at least one permanent magnet.

4. Apparatus according to claim 1, **characterized in that** the sources (4a, 4b) of magnetic field consist of a combination of at least one permanent magnet and at least one magnetic coil (7a, 7b).

5. Apparatus according to any of claims 1 to 4, **characterized in that** the cathodes (2a, 2b) are arranged so as to pivot.

6. Apparatus according to any of claims 1 to 5, **characterized in that** the sources (4a, 4b) of magnetic field are arranged as immovable.

7. Apparatus according to any of claims 1 to 5, **characterized in that** the sources (4a, 4b) of magnetic field are arranged so as to pivot.

8. Apparatus according to claim 7, **characterized in that** the cathodes (2a, 2b) are arranged as immovable.

9. Apparatus according to any of claims 1 to 8, **characterized in that** the cathodes (2a, 2b) are arranged in the central region of the coating chamber (1).

10. Apparatus according to any of claims 1 to 9, **characterized in that** the cathodes (2a, 2b) are accommodated between the wall of coating chamber (1) and the objects to be coated.

11. Apparatus according to claim 10, **characterized in that** the anode (3) is divided at least in two sections arranged at the sides of the cathodes (2a, 2b).

## Patentansprüche

1. Vorrichtung zur Verdampfung von Materialien für eine Beschichtung von Objekten mittels einer physikalischen Methode unter Verwendung eines elektrischen Niederspannungs-Bogens, mit einem elektrischen Bogenzünder, mit einer Beschichtungskammer (1), mit einer Quelle des magnetischen Feldes und mit einer Anode (3) und mit einer zylindrischen Kathode (2a) des elektrischen Bogens, **dadurch gekennzeichnet, daß** diese mindestens eine zweite zylindrische Kathode (2b) umfaßt, so daß diese Kathoden (2a, 2b) symmetrisch in Bezug auf die Anode (3) angeordnet sind, und eine Quelle (4a, 4b) des magnetischen Feldes innerhalb jeder Kathode (2a, 2b) untergebracht ist, so daß jede Kathode (2a, 2b) und die innerhalb dieser Kathode (2a, 2b) unterbrachte Quelle (4a, 4b) zum Drehen jede in Bezug zu der anderen in der Beschichtungskammer angeordnet sind.

2. Vorrichtung nach Anspruch 1, **dadurch gekennzeichnet, daß** die Quellen (4a, 4b) des magnetischen Feldes aus mindestens einer Magnetspule (7a, 7b) bestehen.

3. Vorrichtung nach Anspruch 1, **dadurch gekennzeichnet, daß** die Quellen (4a, 4b) des magnetischen Feldes aus mindestens einem Permanentmagnet bestehen.

4. Vorrichtung nach Anspruch 1, **dadurch gekennzeichnet, daß** die Quellen (4a, 4b) des magnetischen Feldes aus einer Kombination von mindestens einem Permanentmagnet und mindestens einer Magnetspule (7a, 7b) bestehen.

5. Vorrichtung nach einem der Ansprüche 1 bis 4, **dadurch gekennzeichnet, daß** die Kathoden (2a, 2b) drehbar angeordnet sind.

6. Vorrichtung einem der Ansprüche 1 bis 5, **dadurch gekennzeichnet, daß** die Quellen (4a, 4b) des magnetischen Feldes unbeweglich angeordnet sind.

7. Vorrichtung einem der Ansprüche 1 bis 5, **dadurch gekennzeichnet, daß** die Quellen (4a, 4b) des magnetischen Feldes drehbar angeordnet sind.

8. Vorrichtung nach Anspruch 7, **dadurch gekennzeichnet, daß** die Kathoden (2a, 2b) unbeweglich angeordnet sind.

9. Vorrichtung nach einem der Ansprüche 1 bis 8, **dadurch gekennzeichnet, daß** die Kathoden (2a, 2b) in dem Zentralbereich der Beschichtungskammer (1) angeordnet sind.

10. Vorrichtung nach einem der Ansprüche 1 bis 9, **dadurch gekennzeichnet, daß** die Kathoden (2a, 2b) sich zwischen der Wand der Beschichtungskammer (1) und den zu beschichtenden Objekten befinden.

11. Vorrichtung nach Anspruch 10, **dadurch gekennzeichnet, daß** die Anode (3) in mindestens zwei an Seiten von den Kathoden (2a, 2b) angeordneten Sektionen geteilt ist.

## Revendications

1. Appareil utilisant l'évaporation de matériaux servant au revêtement d'objets par une méthode physique grâce à un arc électrique à basse tension, avec un marteau initiant l'arc électrique et une chambre de dépôt (1), avec une source de champ magnétique ainsi qu'une anode (3) et une cathode cylindrique (2a) par arc électrique, **caractérisé par le fait qu'**il comprend en plus au moins une deuxième cathode cylindrique (2b) telle que lesdites cathodes (2a, 2b) sont arrangées symétriquement par rapport à ladite anode (3) et une source (4a, 4b) de champ magnétique est placée à l'intérieur de chaque cathode (2a, 2b) de façon que chaque cathode (2a, 2b) et la source (4a, 4b) située à l'intérieur d'elle sont assemblées de façon à tourner l'une par rapport à l'autre dans ladite chambre de dépôt (1).

2. Appareil selon la revendication 1, qui est **caractérisé par le fait que** les sources (4a, 4b) de champ magnétique consistent d'au moins une bobine magnétique (7a, 7b).

3. Appareil selon la revendication 1, qui est **caractérisé par le fait que** les sources (4a, 4b) de champ magnétique consistent d'au moins un aimant permanent.

4. Appareil selon la revendication 1, qui est **caractérisé par le fait que** les sources (4a, 4b) du champ magnétique consistent d'une combinaison d'au moins un aimant permanent et d'au moins une bobine magnétique (7a, 7b).

5. Appareil selon une des revendications 1 à 4, qui est **caractérisé par le fait que** les cathodes (2a, 2b) sont arrangées de façon à tourner sur elles-mêmes.

6. Appareil selon une des revendications 1 à 5, qui est **caractérisé par le fait que** les sources (4a, 4b) de champ magnétique ont une position fixe.

7. Appareil selon une des revendications 1 à 5, qui est **caractérisé par le fait que** les sources (4a, 4b) de champ magnétique sont capables de pivoter.

8. Appareil selon la revendication 7, qui est **caractérisé par le fait que** les cathodes (2a, 2b) ont une position fixe.

9. Appareil selon une des revendications 1 à 8, qui est **caractérisé par le fait que** les cathodes (2a, 2b) sont placées dans la zone centrale de la chambre de dépôt (1).

10. Appareil selon une des revendications 1 à 9, qui est **caractérisé par le fait que** les cathodes (2a, 2b) sont placées entre la paroi de la chambre de dépôt (1) et les objets à revêtir.

11. Appareil selon la revendication 10, qui est **caractérisé par le fait que** l'anode (3) est divisée en au moins deux parties disposées sur les côtés des cathodes (2a, 2b).
